# EUROPÄISCHE PATENTSCHRIFT

(11) **EP 3 362 309 B1**
(45) Veröffentlichungstag und Bekanntmachung des Hinweises auf die Patenterteilung: **12.06.2019**
(21) Anmeldenummer: 16775249.2
(22) Anmeldetag: 30.09.2016
(51) Int. Cl.: B60K 35/00, B60K 37/04, G02B 27/01, B60R 11/00

(54) **DECKELSYSTEM UND GEHÄUSE MIT DEM DECKELSYSTEM**
COVER SYSTEM AND HOUSING WITH SAID COVER SYSTEM
SYSTÈME DE RECOUVREMENT ET BOÎTIER MUNI DU SYSTÈME DE RECOUVREMENT

(30) Priorität: 14.10.2015 DE 102015013340
(43) Veröffentlichungstag der Anmeldung: 22.08.2018
(73) Patentinhaber: Audi AG, 85045 Ingolstadt (DE)
(72) Erfinder: WALL, Christian, 85122 Hitzhofen (DE)
(86) Internationale Anmeldenummer: PCT/EP2016/073469
(87) Internationale Veröffentlichungsnummer: WO 2017/063903

(56) Entgegenhaltungen:
- WO-A1-2012/169557
- JP-A- 2006 065 092
- US-B1- 6 837 581

## Beschreibung

Die vorliegende Erfindung betrifft ein Deckelsystem mit den Merkmalen gemäß Anspruch 1 und ein Gehäuse mit den Merkmalen gemäß Anspruch 6.

Um Fahrern von Kraftfahrzeugen Informationen in Form von Text, Graphiken, virtuellen Bildern etc. auf eine komfortable, möglichst wenig vom Verkehr ablenkende Weise und ohne oder ohne große Anpassung der Sehentfernung der Augen (Akkommodation) anzeigen zu können ist es seit längerem bekannt, in Kraftfahrzeugen ein oder mehrere Head-Up-Displays vorzusehen.

Bei Head-Up-Displays wird bekanntermaßen Licht einer bildgebenden Einrichtung, etwa auf Basis einer Flüssigkristallanzeige, auf eine lichtdurchlässige Reflektionsfläche projiziert. Die Reflektionsfläche, bei der es sich bspw. um einen Teil der Frontscheibe eines Kraftfahrzeugs oder um eine gegebenenfalls kinematisch ein- und ausfahrbare sog. "Combinerscheibe" handeln kann, ist in Kraftfahrzeugen oftmals in Richtung zur Fahrzeugfront hinter dem Lenkrad des Kraftfahrzeugs angeordnet.

Um eine möglichst kleinen Bauraum zu realisieren, ist bei Head-Up-Displays oftmals eine Optikeinheit vorgesehen mit der der Strahlengang des von der bildgebenden Einrichtung abgestrahlten Lichts in Richtung der Reflektionsfläche umgelenkt bzw. "gefaltet" werden kann. Derartige Head-Up-Displays sind gerade für Vorrichtungen, wie etwa Kraftfahrzeuge, von Interesse, bei denen nur ein sehr begrenzter Bauraum zur Verfügung steht.

Bei Kraftfahrzeugen stellt die Integration der bildgebenden Einrichtung, die gegebenenfalls eine separate Lichtquelle aufweisen kann, sowie einer Optikeinheit eine besondere Herausforderung dar.

Zum einen ist es nämlich wünschenswert, die genannten Elemente eines Head-Up-Display vollständig in das Innere der Schalttafel bzw. des Armaturenbretts eines Kraftfahrzeugs zu integrieren. Zum anderen ist es wünschenswert, ein "Verschlusssystem" vorzusehen, mit dem im ausgeschalteten Zustand des Head-Up-Display die bildgebende Einrichtung und die Optikeinheit weitestgehend gegen die Umwelt verschlossen werden können, um eine Verschmutzung dieser Einrichtungen möglichst gering zu halten. Hierbei ist es wünschenswert, dass ein solches Verschlusssystem im geschlossenen Zustand auch möglichst bündig mit den das Verschlusssystem umgebenden Oberflächen abschließt.

Für die vorstehend skizzierten Probleme sind Lösungen aus dem Stand der Technik bekannt. Diese sind jedoch sehr aufwändig in Bezug auf die Kinematik, benötigen vergleichsweise viel Bauraum, der gerade im Bereich der Schalttafel oder des Armaturenbretts eines Kraftfahrzeugs oftmals nicht zur Verfügung steht, oder ermöglichen keinen "gefalteten" Strahlengang des Lichts.

So beschreibt etwa die US 2008/0285138 A1 eine Anzeigevorrichtung für ein Kraftfahrzeug, die eine Lichtquelle zum Erzeugen einer anzeigbaren Information und eine wenigstens teilweise transparente, einziehbare Scheibe aufweist, die die Information in Richtung eines Benutzers des Kraftfahrzeugs reflektiert, wobei die Scheibe an einer beweglichen Halterung befestigt ist, die zwischen einer Ruheposition und wenigstens einer Anzeigeposition bewegbar ist, und wobei die Scheibe eingezogen ist, wenn sich die bewegliche Halterung in der Ruheposition befindet und die Scheibe herausgefahren ist, wenn sich die bewegliche Halterung in einer Anzeigeposition befindet. Es kann ein Gehäuse mit zwei Klappen vorgesehen sein, durch das die bewegliche Halterung, die Scheibe und die Lichtquelle vollständig umschlossen sind, wenn die Scheibe eingezogen ist.

Aus der US 6,837,581 B1 ist ein Spiegelanordnungs-Entfaltungssystem einer Anzeigeeinheit bekannt, die einen Abbildungsspiegel und eine Verlängerungsverbindungsanordnung aufweist, die mit dem Abbildungsspiegel gekoppelt ist. Die Verlängerungsverbindungsanordnung weist eine Zugfe-der auf, die mit einem Gehäuse der Anzeigeeinheit gekoppelt ist. Das Entfaltungssystem weist eine Kompressionsverbindungsanordnung auf, die mit der Verlängerungsverbindungsanordnung gekoppelt ist, wobei die Kompressionsverbindungsänordnung eine Druckfeder aufweist. Das System umfasst auch einen Faltspiegel, der mit der Kompressionsverbindungsanordnung gekoppelt ist. Die Zugfeder ist so ausgebildet, dass sie sich zumindest teilweise entspannt, wenn der Abbildungsspiegel aus einer abgesenkten Position freigegeben wird, wodurch sich der Abbildungsspiegel in eine zumindest teilweise ausgefahrene Position dreht. Die Druckfeder ist so ausgebildet, dass sie sich entspannt, wenn sich die Zugfeder zumindest teilweise entspannt, wodurch sich der Faltspiegel von einer abgesenkten Position in eine ausgefahrene Position dreht.

Die JP 2006-065092 A beschreibt ein Head-Up Display mit einem Combiner und einem Faltspiegel, wobei der Anzeigeteil des Combiners und der Faltspiegel gekrümmte Flächen aufweisen. Der Combiner kann in einem nicht benutzten Zustand des Head-Up Display in einem mittels zwei aneinandergrenzenden Deckeln geschlossenen Gehäuses angeordnet sein. Zum Herausklappen des Combiners in einen betriebsfertigen Zustand des Head-Up Display können beide Deckel nach außen aufgeklappt werden, wobei ein Teil einer der Deckel sich in den Innenraum des Gehäuses bewegt.

Und aus der WO 2012/169557 A1 ist eine Head-Up-Display-Vorrichtung mit einem Deckelkörper bekannt, der eine Öffnung in der oberen Oberfläche eines Hauptkörpers bedeckt. Der Deckelkörper ist aus zwei an der Öffnung aneinanderstoßenden Deckeln ausgebildet, wobei Armteile der beiden Deckel über eine erste Verbindung miteinander gekoppelt sind, die eine Drehkraft überträgt. Der erste Armteil des ersten Deckels und ein Armteil des Combiners sind über die zweite Verbindung, die eine Drehkraft überträgt, miteinander gekoppelt. Bei einem Öffnungsvorgang des ersten Deckels werden die Öffnung des zweiten Deckels und das Drehen des Combiners von einer Gehäuseposition innerhalb der Öffnung des Hauptkörpers in eine Gebrauchsposition bewirkt.

Es ist Aufgabe der vorliegenden Erfindung, ein neuartiges Deckelsystem und ein neuartiges Gehäuse mit dem Deckelsystem bereitzustellen, mit denen Nachteile des Stands der Technik überwunden oder doch verringert werden können..

Diese Aufgabe wird gelöst durch das Deckelsystem gemäß Anspruch 1 und das Gehäuse gemäß Anspruch 6. Vorteilhafte Weiterbildungen und Ausgestaltungen des Deckelsystems und des Gehäuses sind Gegenstand der Unteransprüche.

Gemäß der vorliegenden Erfindung wird ein Deckelsystem zum Öffnen und Schließen einer Seite eines Gehäuses, das zur Aufnahme einer bildgebenden Einrichtung und einer Optikeinheit für ein Head-Up-Display vorgesehen ist, vorgeschlagen, wobei
- das Deckelsystem wenigstens einen ersten Deckelteil und einen zweiten Deckelteil aufweist,
- der erste Deckelteil und der zweite Deckelteil in einem ersten Zustand aneinandergrenzen und zusammen eine geschlossene Fläche mit vier Eckbereichen ausbilden.
- eine erste Kante des ersten Deckelteils eine äußere Kante der geschlossenen Fläche ausbildet, wobei die Enden der ersten Kante des ersten Deckelteils unmittelbar an zwei erste benachbarte Eckbereiche der geschlossenen Fläche angrenzen,
- eine erste Kante des zweiten Deckelteils zumindest einen Teil einer weiteren äußeren Kante der geschlossenen Fläche ausbildet, wobei die Enden der ersten Kante des zweiten Deckelteils entweder unmittelbar an zwei zweite benachbarte, von den zwei ersten benachbarten Eckbereichen verschiedene Eckbereiche der geschlossenen Fläche angrenzen oder in der Kante der geschlossenen Fläche angeordnet sind, die sich zwischen den zwei zweiten benachbarten Eckbereichen der geschlossenen Fläche erstreckt, und zur Ausbildung eines zweiten Zustands
- die erste Kante des ersten Deckelteils um eine Achse, die parallel zu einer durch die Enden der ersten Kante des ersten Deckelteils gedachten Geraden verläuft, um einen ersten vorgebbaren Winkel in eine vorgebbare Richtung beweglich ist,
- die erste Kante des zweiten Deckelteils um eine Achse, die parallel zu einer durch die Enden der ersten Kante des zweiten Deckelteils gedachten Geraden verläuft, um einen zweiten vorgebbaren Winkel in die vorgebbare Richtung beweglich ist, und
- die erste Kante des zweiten Deckelteils in eine vorgebbare Richtung um eine vorgebbare Strecke relativ zu der Fläche beweglich ist, die durch eine gedachte geradlinige Verbindung der vier Eckbereiche der geschlossenen Fläche definiert ist.

Das Deckelsystem gemäß der vorliegenden Erfindung ist dadurch gekennzeichnet, dass
- der erste Deckelteil wenigstens eine zweite Kante aufweist, die mit der Kante der geschlossenen Fläche fluchtet, die sich zwischen den zweiten zwei benachbarten Eckbereichen der geschlossenen Fläche erstreckt, und
- der erste Deckelteil im Bereich seiner wenigstens einen zweiten Kante und der zweite Deckelteil im Bereich seiner ersten Kante um die Achse, die parallel zu einer durch die Enden der ersten Kante des zweiten Deckelteils gedachten Geraden verläuft, gegeneinander verdrehbar miteinander verbunden sind.

Durch das erfindungsgemäße Deckelsystem ergeben sich mehrere Vorteile gegenüber den aus dem Stand der Technik bekannten Lösungen.

Zum einen ermöglicht das erfindungsgemäße Deckelsystem eine kostengünstige Doppelnutzung des Deckelsystems sowohl zur Abdeckung (zum Verschluss gegenüber der Umgebung) einer bildgebenden Einrichtung sowie einer Optikeinheit eines Head-Up-Display, als auch zur Lichtkanalgestaltung, d.h. zur Freigabe des Strahlengangs für das von der bildgebenden Einrichtung ausgestrahlte Licht, und des Lichts, das von der Optikeinheit hin zu einer Reflektionsfläche umgelenkt wird.

Darüber hinaus erfordert das erfindungsgemäße Deckelsystem nur eine einfache und kostengünstig zu realisierende Kinematik zum Öffnen und Schließen des Deckelsystems.

Somit kann mittels des erfindungsgemäßen Deckelsystems im Gegensatz zu vorbekannten Lösungen ein sehr kleiner Bauraum realisiert werden, der für die bildgebende Einrichtung und die Optikeinheit eines Head-Up-Display erforderlich ist. Hierdurch ergibt sich auch ein sehr kleiner Bauraum etwa für ein vollständiges Combiner-Head-Up-Display. Durch einen kleinen Bauraum, d.h. durch ein kleines Volumen eines entsprechenden Gehäuses im geöffneten Zustand ergibt sich als weiterer Vorteil, dass auch der mögliche Eintrag und die Ablagerung von Verunreinigungen auf der bildgebenden Einrichtung und der Optikeinheit während des Betriebs eines Head-Up-Display gering gehalten werden kann.

Gemäß einer ersten vorteilhaften Weiterbildung des Deckelsystems ist bei der durch den ersten und den zweiten Deckelteil im ersten Zustand ausgebildeten geschlossenen Fläche die Länge der Kante zwischen den zwei ersten Eckbereichen der geschlossenen Fläche größer ist als die Länge der Kante zwischen den zwei zweiten Eckbereichen der geschlossenen Fläche.

Weitere Vorteile ergeben sich, wenn, wie dies gemäß einer zweiten vorteilhaften Weiterbildung des Deckelsystems vorgesehen ist,
- der zweite Deckelteil eine Fläche mit vier Eckbereichen aufweist, wobei die Enden der ersten Kante des zweiten Deckelteils zwei ersten benachbarten Eckbereichen des zweiten Deckelteils entsprechen,
- die Enden einer zweiten Kante des zweiten Deckelteils zwei zweiten benachbarten, von den zwei ersten benachbarten Eckbereichen des zweiten Deckelteils verschiedenen Eckbereichen des zweiten Deckelteils entsprechen, und wobei
- die erste Kante eine größere Länge aufweist als die zweite Kante.

Bei dem Deckelsystem gemäß der vorliegenden Erfindung kann weiter in vorteilhafter Weise
- eine oder beide zu seiner ersten Kante unmittelbar benachbarte(n) Kante(n) des ersten Deckelteils mittels eines flexiblen Elements mit einer Umrandung für das Deckelsystem verbunden sein, und/oder
- eine oder beide zu seiner ersten Kante unmittelbar benachbarte(n) Kante(n) des zweiten Deckelteils mittels eines flexiblen Elements mit dem ersten Deckelteil verbunden sein.

Gemäß noch einer weiteren vorteilhaften Weiterbildung des Deckelsystems kann an der ersten Kante und/oder an der zweiten Kante des zweiten Deckelteils ein Abstreifmittel (zum Abstreifen von Verunreinigungen von der Oberfläche einer bildgebenden Einrichtung und/oder einer Optikeinheit) angeordnet sein.

Die vorliegende Erfindung umfasst auch ein Gehäuse, das zur Aufnahme einer bildgebenden Einrichtung und einer Optikeinheit für ein Head-Up-Display vorgesehen ist. Das Gehäuse ist dadurch gekennzeichnet, dass es ein erfindungsgemäßes Deckelsystem oder eines seiner vorteilhaften Weiterbildungen aufweist.

Gemäß einer ersten vorteilhaften Weiterbildung des Gehäuses kann dieses ein elektromotorisches, elektropneumatisches, elektrohydraulisches und/oder Feder-Mittel zum Bewegen des ersten Deckelteils und/oder des zweiten Deckelteils von dem ersten Zustand zu dem zweiten Zustand und/oder von dem zweiten Zustand zu dem ersten Zustand aufweisen.

Des Weiteren kann das Gehäuse in vorteilhafter Weise
- ein Haltemittel zum lösbaren Halten des ersten und/oder zweiten Deckelteils in dem ersten und/oder zweiten Zustand, und/oder
- wenigstens ein Endanschlagelement für den ersten und/oder zweiten Deckelteil aufweisen.

Gemäß noch weiteren vorteilhaften Weiterbildungen kann das Gehäuse
- mit einer Combiner-Einrichtung mit einer Combinerscheibe verbunden sein oder eine Combinerscheibe aufweisen;
- eine bildgebende Einrichtung aufweisen, die Flüssigkristalle, Licht emittierende Dioden, organische Licht emittierende Dioden, eine Elektrolumineszenzeinrichtung, eine Feldemissionseinrichtung, ein Mikrospiegelarray und/oder eine Elektronenstrahlröhre aufweist; und/oder
- eine Optikeinheit aufweisen, die wenigstens einen Spiegel zum Projizieren des von der bildgebenden Einrichtung abgestrahlten Lichts zu einer Reflektionsfläche aufweist.

Die vorliegende Erfindung wird anhand der beigefügten Zeichnungen näher erläutert.

Dabei zeigen:
- Fig. 1: eine schematische Darstellung eines beispielhaften Deckelsystems gemäß der vorliegenden Erfindung in einem ersten, geschlossenen Zustand und in einem zweiten, geöffneten Zustand;
- Fig. 2: eine schematische Darstellung eines beispielhaften Gehäuses mit einem Deckelsystem gemäß der vorliegenden Erfindung im geschlossenen Zustand, wobei das Gehäuse lediglich zur besseren Veranschaulichung der Erfindung als ein Bauteil einer Head-Up-Display-Einrichtung mit einer Combinerscheibe dargestellt ist;
- Fig. 3: eine schematische Schnittansicht des beispielhaften Gehäuses gemäß Fig. 2;
- Fig. 4: eine schematische Schnittansicht des beispielhaften Gehäuses gemäß Fig. 2 mit dem Deckelsystem gemäß der vorliegenden Erfindung in einem zweiten, geöffneten Zustand;
- Fig. 5: eine schematische Schnittansicht eines beispielhaften Gehäuses gemäß der vorliegenden Erfindung mit einer ebenfalls lediglich schematischen und beispielhaften Darstellung eines möglichen Verlaufs des Strahlengangs eines von einer bildgebenden Einrichtung abgestrahlten und von einer Optikeinheit in Richtung einer Combinerscheibe umgelenkten Lichts;
- Fig. 6: eine schematische Darstellung eines weiteren Beispiels des Deckelsystems gemäß der vorliegenden Erfindung.

Die Darstellungen in den Figuren sind rein schematisch und nicht maßstabsgerecht. Innerhalb der Figuren sind gleiche oder ähnliche Elemente mit gleichen Bezugszeichen versehen.

Die nachfolgend erläuterten Ausführungsbeispiele stellen bevorzugte Ausführungsformen der vorliegenden Erfindung dar. Die vorliegende Erfindung ist selbstverständlich nicht auf diese Ausführungsformen beschränkt.

Die in der obigen Beschreibung genannten Merkmale und Merkmalskombinationen sowie die in der nachfolgenden Beschreibung von Ausführungsformen, Ausführungsbeispielen und der Figurenbeschreibung genannten und/oder in den Figuren alleine gezeigten Merkmale und Merkmalskombinationen sind nicht nur in der jeweils angegebenen Kombination, sondern auch in anderen Kombinationen oder in Alleinstellung verwendbar, ohne den Rahmen der vorliegenden Erfindung zu verlassen.

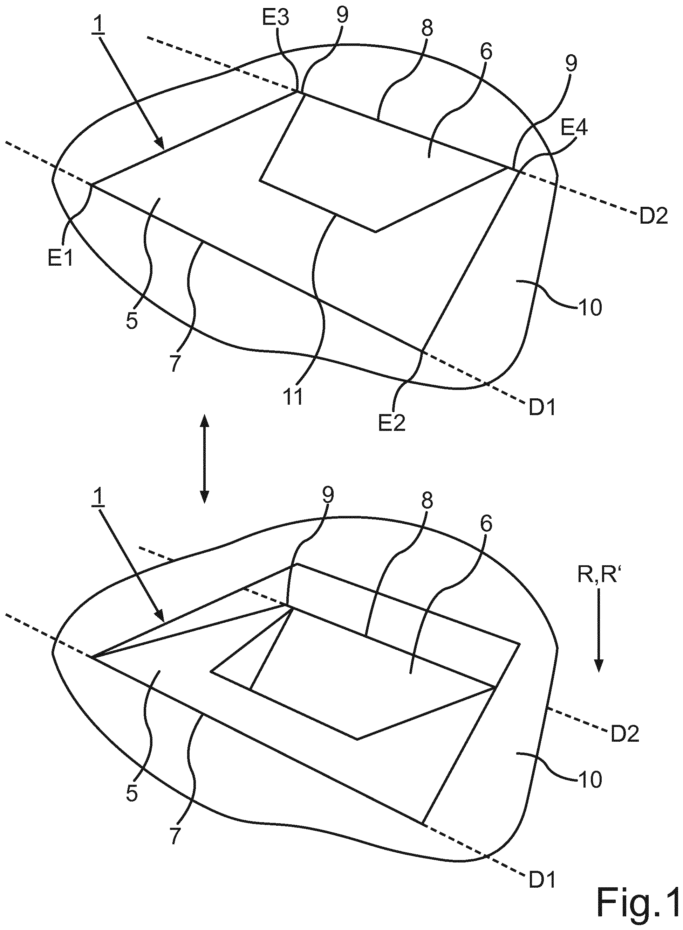

In den Fig. 1 bis 5 und in den nachfolgenden Ausführungen wird überwiegend auf ein Deckelsystem 1 eingegangen, bei dem der erste 5 und der zweite 6 Deckelteil in einem geschlossenen Zustand eine trapezförmige oder annähernd trapezförmige Fläche einnehmen. Die vorliegende Erfindung ist selbstverständlich nicht auf die in diesen Figuren dargestellte und in der zugehörigen Beschreibung erläuterte Ausgestaltung des Deckelsystems 1 beschränkt.

Es ist von der vorliegenden Erfindung umfasst und für einen Fachmann offensichtlich, dass zur Erreichung der erfindungsgemäßen Vorteile das Deckelsystem 1 im ersten Zustand bspw. auch eine rechteckige Form aufweisen kann, dass bspw. der erste 5 und das zweite 6 Deckelteil gleich lange erste Kanten 7, 8 aufweisen können, dass bspw. der erste 5 und der zweite 6 Deckelteil jeweils eine rechteckige Form aufweisen können, dass bspw. die Größenverhältnisse zwischen dem ersten 5 und dem zweiten 6 Deckelteil variiert werden können (der zweite Deckelteil 6 kann bspw. so groß wie oder größer als der erste Deckelteil 5 sein), dass bspw. die Kanten des ersten 5 und zweiten 6 Deckelteils nicht geradlinig verlaufen müssen, etc.

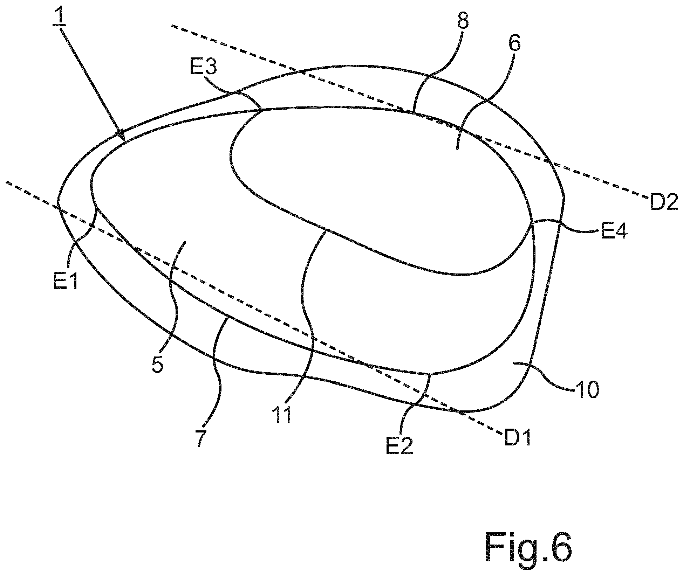

So können bspw. Kanten des ersten 5 und zweiten 6 Deckelteils auch eine derart gebogene Form aufweisen, dass zumindest einige der oben erwähnten Eckbereiche E1, E2, E3, E4 und Eckbereiche des zweiten Deckelteils 6 nicht mehr als solche erkennbar sind (auch wenn diese in einem solchen Fall noch definiert oder definierbar sind). Ein schematisches Beispiel für ein derartiges Deckelsystem 1 ist in Fig. 6 in seinem ersten, geschlossenen Zustand dargestellt.

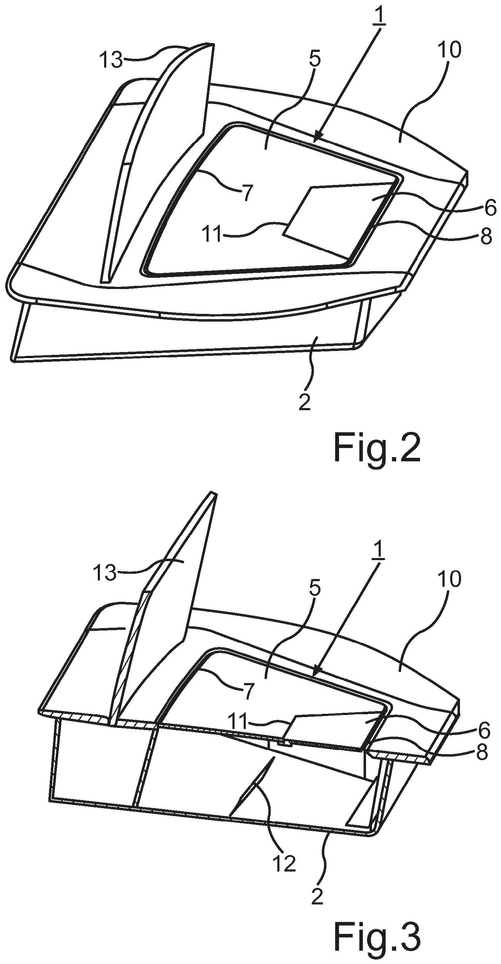

Bei den Eckbereichen E1, E2, E3, E4 sowie bei den Eckbereichen des zweiten Deckelteils 6 kann es sich in einem einfachen Fall um Eckpunkte handeln, die Eckbereiche können aber auch (wie dies etwa in den Fig. 2 bis 4 angedeutet ist) abgerundete Ecken aufweisen (wobei in einem solchen Fall bspw. die Fläche, die durch die Eckbereiche E1, E2, E3, E4 definiert ist, etwa durch eine gedachte Verbindung der Mittelpunkt der abgerundeten Ecken mittels Geraden aufgespannt werden kann), oder es kann sich bei den Eckbereichen E1, E2, E3, E4 und/oder den Eckbereichen des zweiten Deckelteils 6 um in geeigneter Weise definierte Punkte handeln (vgl. das in Fig. 6 gezeigte Beispiel).

Bei dem in den Figuren beispielhaft und schematisch dargestellten Deckelsystemen 1 ist lediglich zur besseren Veranschaulichung der Erfindung das Deckelsystem 1 zusammen mit einer Umrandung 10 dargestellt. Eine solche Umrandung 10 stellt jedoch allenfalls ein optionales, weiteres Element des Deckelsystems 1 oder des Gehäuses 2 dar.

Wie im oberen Bereich von Fig. 1 dargestellt ist, weist das Deckelsystem 1 gemäß der vorliegenden Erfindung
- wenigstens einen ersten Deckelteil 5 und einen zweiten Deckelteil 6 auf,
- grenzen der erste Deckelteil 5 und der zweite Deckelteil 6 in einem ersten (geschlossenen) Zustand aneinander und bilden zusammen eine geschlossene Fläche mit vier Eckbereichen E1, E2, E3, E4 aus.

Bei dem Deckelsystem 1 gemäß der vorliegenden Erfindung
- bildet eine erste Kante 7 des ersten Deckelteils 5 eine äußere Kante der geschlossenen Fläche aus, wobei die Enden der ersten Kante 7 des ersten Deckelteils 5 unmittelbar an zwei erste benachbarte Eckbereiche E1, E2 der geschlossenen Fläche angrenzen,
- bildet eine erste Kante 8 des zweiten Deckelteils 6 zumindest einen Teil einer weiteren äußeren Kante der geschlossenen Fläche aus, wobei die Enden der ersten Kante 8 des zweiten Deckelteils 6 entweder unmittelbar an zwei zweite benachbarte, von den zwei ersten benachbarten Eckbereichen E1, E2 verschiedene Eckbereiche E3, E4 der geschlossenen Fläche angrenzen oder in der Kante der geschlossenen Fläche angeordnet sind, die sich zwischen den zwei zweiten benachbarten Eckbereichen E3, E4 der geschlossenen Fläche erstreckt,
   und sind zur Ausbildung eines zweiten (geöffneten) Zustands
- die erste Kante 7 des ersten Deckelteils 5 um eine Achse D1, die parallel zu einer durch die Enden der ersten Kante 7 des ersten Deckelteils 5 gedachten Geraden verläuft, um einen ersten vorgebbaren Winkel in eine vorgebbare Richtung R beweglich,
- die erste Kante 8 des zweiten Deckelteils 6 um eine Achse D2, die parallel zu einer durch die Enden der ersten Kante 8 des zweiten Deckelteils 6 gedachten Geraden verläuft, um einen zweiten vorgebbaren Winkel in die vorgebbare Richtung R beweglich, und
- die erste Kante 8 des zweiten Deckelteils 6 in eine vorgebbare Richtung R' um eine vorgebbare Strecke relativ zu der Fläche beweglich, die durch eine gedachte geradlinige Verbindung der vier Eckbereiche E1, E2, E3, E4 der geschlossenen Fläche definiert ist.

Soweit in der vorliegenden Anmeldung davon gesprochen wird, dass ein erster Deckelteil 5 und ein zweiter Deckelteil 6. "aneinander grenzen", so ist darunter auch zu verstehen, dass sich diese Teile in wenigstens einem Teil ihrer Randbereiche überlappen können, wie dies in Fig. 3 in Bezug auf die Kante 11 des zweiten Deckelteils 6 in Bezug auf die "angrenzende" Kante des ersten Deckelteils 5 beispielhaft dargestellt ist.

Werden der erste Deckelteil 5 und der zweite Deckelteil 6 von dem im oberen Bereich von Fig. 1 dargestellten ersten, d.h. geschlossenen Zustand in den zweiten, d.h. geöffneten Zustand bewegt, wie dies vorstehend beschrieben ist, ergibt sich beispielsweise ein geöffneter Zustand des Deckelsystems 1, wie er im unteren Bereich von Fig. 1 abgebildet ist.

Der in Fig. 1 abgebildete Doppelpfeil soll die mögliche Bewegung des ersten 5 und des zweiten 6 Deckelteils von dem ersten zu dem zweiten und von dem zweiten zu dem ersten Zustand symbolisieren.

Der Lage der Achse D1 ist nicht besonders beschränkt, wird in vorteilhafter Weise jedoch entweder durch die Enden der ersten Kante 7 des ersten Deckelteils 5 verlaufen, oder bspw. bei einer nach außen (konvex) gekrümmten ersten Kante 7 (vgl. Fig. 6) in dem Bereich ab den Enden der ersten Kante 7 und dem Scheitelbereich der ersten Kante 7 des ersten Deckelteils 5.

Schließt das Deckelsystem 1 in dem ersten, geschlossenen Zustand oberflächenbündig oder nahezu oberflächenbündig mit einer das Deckelsystem 1 umgebenden Umrandung 10 ab, so kann auf diese Weise erreicht werden, dass bei einer Bewegung des ersten Deckelteils 5 um die Achse D1 in Richtung R kein oder nur ein kleiner Bereich des ersten Deckelteils 5 über eine gegebene Umrandung 10 hinausragt.

Ähnliche Überlegungen gelten auch für die Achse D2. Wie oben bereits erwähnt, wird die erste Kante 8 des zweite Deckelteils 6 zur Ausbildung eines zweiten (geöffneten) Zustands um einen zweiten vorgebbaren Winkel in die vorgebbare Richtung R bewegt, und es wird die erste Kante 8 des zweiten Deckelteils 6 in die vorgebbare Richtung R' um eine vorgebbare Strecke relativ zu der Fläche bewegt, die durch eine gedachte geradlinige Verbindung der Eckbereiche E1, E2, E3, E4 (je eine Gerade von E1 zu E2, von E2 zu E3, von E3 zu E4 und von E4 zu E1) der geschlossenen Fläche definiert ist.

Um hierbei die gesamte vorgegebene Stecke oder doch wenigstens einen großen Anteil davon zwischen der ersten Kante 8 und einer Umrandung 10 freizugeben, ist es von Vorteil, wenn die zweite Achse D2 entweder durch die Enden der ersten Kante 8 des zweiten Deckelteils 6 verläuft, oder bspw. bei einer nach außen (konvex) gekrümmten ersten Kante 8 (vgl. Fig. 6) in dem Bereich ab den Enden der ersten Kante 8 und dem Scheitelbereich der ersten Kante 8 des zweiten Deckelteils 6.

Auch die Größe des ersten und des zweiten Winkels ist nicht besonders beschränkt. Der erste und der zweite Winkel können gleich groß oder verschieden voneinander sein. Der erste und der zweite Winkel werden von einem Fachmann in Abhängigkeit von den jeweiligen Erfordernissen und Gegebenheiten gewählt werden, und der erste und zweite Winkel können unabhängig voneinander bspw. einen Wert im Bereich von 5° bis 60° aufweisen, wobei jeder dazwischen liegende Wert innerhalb des angegebenen Bereichs ausdrücklich Gegenstand der Offenbarung ist (d.h. als Wert für den ersten und den zweiten Winkel können unabhängig voneinander bspw. 5°, 6°, 7°, 8°, 9°, 10°, 11°, 12°, 13°, 14°, 15°, 16°, 17°, 18°, 19°, 20°, 21°, 22°, 23°, 24°, 25°, 26°, 27°, 28°, 29°, 30°, 31°, 32°, 33°, 34°, 35°, 36°, 37°, 38°, 39°, 40°, 41°, 42°, 43°, 44°, 45°, 46°, 47°, 48°, 49°, 50°, 51°, 52°, 53°, 54°, 55°, 56°, 57°, 58°, 59° oder 60° vorgegeben sein, wobei zwischen den ganzzahligen Werten liegende Winkel, die etwa um 0,1°, 0,2°, 0,3°, 0,4°, 0,5°, 0,6°, 0,7°, 0,8° oder 0,9° von den ganzzahligen Werten abweichen, ebenfalls von der vorliegenden Erfindung umfasst sind).

Der erste und/oder der zweite vorgebbare Winkel können unabhängig voneinander (etwa für eine Nachjustierung) variierbar sein, müssen also nicht für ein und dieselbe Anwendung von vorneherein fest vorgegeben sein.

Auch die Länge der vorgebbaren Strecke, um die erste Kante 8 des zweiten Deckelteils 6 in eine vorgebbare Richtung R' zur Ausbildung eines zweiten Zustands bzw. zurück zur Ausbildung des ersten Zustands bewegt werden kann ist nicht besonders beschränkt und wird von einem Fachmann in Abhängigkeit von den jeweiligen Erfordernissen und Gegebenheiten gewählt werden. Ist das Deckelsystem 1 gemäß der vorliegenden Erfindung bspw. für ein Head-Up-Display in einem Kraftfahrzeug vorgesehen, so kann als Strecke bspw. ein Bereich von 1 cm bis 20 cm vorgegeben sein, wobei jeder dazwischen liegende Wert innerhalb des angegebenen Bereichs ausdrücklich Gegenstand der Offenbarung ist (d.h. als Wert für die Strecke kann bspw. 1 cm, 2 cm, 3 cm, 4 cm, 5 cm, 6 cm, 7 cm, 8 cm, 9 cm, 10 cm, 11 cm, 12 cm, 13 cm, 14 cm, 15 cm, 16 cm, 17 cm, 18 cm, 19 cm, oder 20 cm vorgegeben sein, wobei eine zwischen den ganzzahligen Werten liegende Strecke, die etwa um 0,1 cm, 0,2 cm, 0,3 cm, 0,4 cm, 0,5 cm, 0,6 cm, 0,7 cm, 0,8 cm oder 0,9 cm von den ganzzahligen Werten abweicht, ebenfalls von der vorliegenden Erfindung umfasst ist). Auch die vorgebbare Strecke kann (etwa aus Gründen einer Nachjustierung) variierbar sein.

Auch bezüglich der Richtungen R, R' bestehen keine besonderen Einschränkungen, und die Richtungen R, R' werden von einem Fachmann in Abhängigkeit von den jeweiligen Erfordernissen und Gegebenheiten gewählt werden. Die Richtungen R, R' sind im unteren Bereich von Fig. 1 lediglich der Einfachheit halber mit einem einzigen geraden Pfeil symbolisiert.

Da die erste Kante 7 des ersten Deckelteils 5 um die Achse D1, und die erste Kante 8 des zweiten Deckelteils 6 um die Achse D2 beweglich ist, verläuft die Richtung R bezüglich dieser Kanten genau genommen nicht geradlinig sondern entlang einer Kreisbahn.

Die Richtung R', in die die erste Kante 8 des zweiten Deckelteils 6 bewegt wird, kann entweder einen geradlinigen Verlauf oder einen Verlauf entlang einer Kreisbahn aufweisen. Letzterer Verlauf ergibt sich bspw. wenn, wie dies in Fig. 2 angedeutet ist, der erste Deckelteil 5 mit einer Umrandung 10 verbunden ist, und der erste Deckelteil 5 und der zweite Deckelteil 6 gegeneinander verdrehbar miteinander verbunden sind.

Von daher ist es für einen Fachmann offensichtlich, dass es sich genau genommen bei der Richtung R um eine Richtung entlang einer Kreisbahn handelt und es sich bei der Richtung R' entweder um eine "gerade" Richtung oder um eine entlang einer Kreisbahn handeln kann. Sofern es sich bei den Richtungen R und/oder R' um solche entlang einer Kreisbahn handelt, symbolisiert der in Fig. 1 eingezeichnete Richtungspfeil somit lediglich die Richtung der Bewegung(en) zu Beginn des Übergangs von dem ersten zu dem zweiten Zustand.

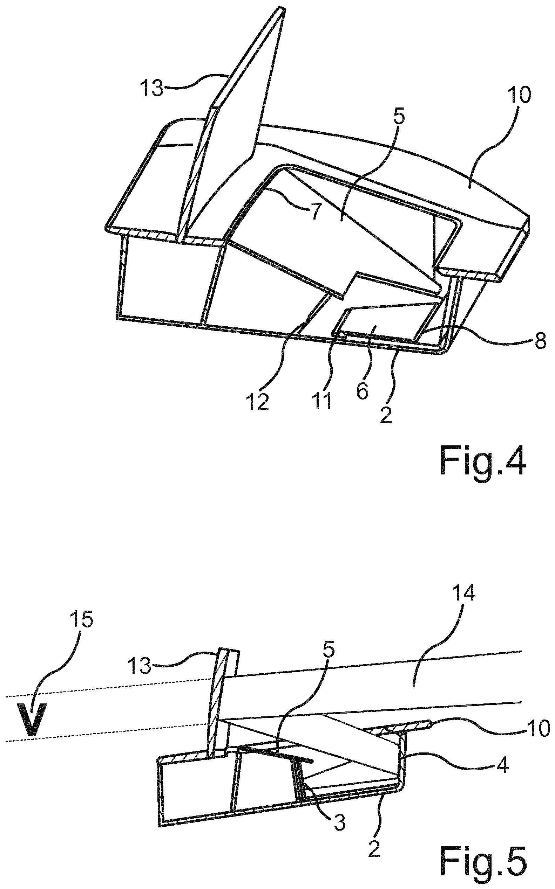

Wie aus Fig. 1 (sowie indirekt auch aus Fig. 4) entnommen werden kann, weisen die (anfängliche) Richtungen R, R' von der durch die Eckbereiche E1, E2, E3, E4 definierten Fläche weg, bei Verwendung des Deckelsystems 1 zum Öffnen und Schließen einer Seite eines Gehäuses 2 bevorzugt in Richtung des Inneren des Gehäuses 2 (vgl. Fig. 2 bis 5). Bei der durch die Eckbereiche E1, E2, E3, E4 definierten Fläche kann es sich in einem einfachen Fall um eine ebene Fläche handeln.

Das in Fig. 1 dargestellte Deckelsystem 1 weist als bevorzugte Ausgestaltung auf, dass
- bei der durch den ersten 5 und den zweiten 6 Deckelteil im ersten Zustand ausgebildeten geschlossenen Fläche die Länge der Kante zwischen den zwei ersten Eckbereichen E1, E2 der geschlossenen Fläche größer ist als die Länge der Kante zwischen den zwei zweiten Eckbereichen E3, E4 der geschlossenen Fläche, und
- der zweite Deckelteil 6 eine Fläche mit vier Eckbereichen aufweist, wobei die Enden der ersten Kante 8 des zweiten Deckelteils 6 zwei ersten benachbarten Eckbereichen des zweiten Deckelteils 6 entsprechen, und die Enden einer zweiten Kante 11 des zweiten Deckelteils 6 zwei zweiten benachbarten, von den zwei ersten benachbarten Eckbereichen des zweiten Deckelteils 6 verschiedenen Eckbereichen des zweiten Deckelteils 6 entsprechen, und wobei die erste Kante 8 eine größere Länge aufweist als die zweite Kante 11.

Erfindungsgemäß ist vorgesehen, dass bei dem Deckelsystem 1
- der erste Deckelteil 5 wenigstens eine zweite Kante 9 aufweist, die mit der Kante der geschlossenen Fläche fluchtet, die sich zwischen den zweiten zwei benachbarten Eckbereichen E3, E4 der geschlossenen Fläche erstreckt und der erste Deckelteil 5 im Bereich seiner wenigstens einen zweiten Kante 9 und der zweite Deckelteil 6 im Bereich seiner ersten Kante 8 um die Achse D2 gegeneinander verdrehbar miteinander verbunden sind.

Eine Ausgestaltung des Deckelsystems 1 gemäß den ersten beiden obigen Spiegelstrichen folgt der Aufweitung des Strahlengangs 14 des von einer bildgebenden Einrichtung 3 abgestrahlten und von einer Optikeinheit 4 umgelenkten Lichts bei einem Head-Up-Display (vgl. Fig. 2 bis 5).

Und die erfindungsgemäße Ausgestaltung des Deckelsystems 1 gemäß dem letzten obigen Spiegelstrich ist insbesondere im Hinblick auf eine besonders einfache Kinematik zum Öffnen und Schließen des Deckelsystems 1 (Verbringen des Deckelsystems 1 von einem ersten zu einem zweiten und von einem zweiten zu einem ersten Zustand) von Vorteil. Aufgrund der Verbindung zwischen dem ersten Deckelteil 5 im Bereich seiner wenigstens einen zweiten Kante 9 und dem zweite Deckelteil 6 im Bereich seiner ersten Kante 8 sowie der gegenseitigen Verdrehbarkeit der beiden Deckelteile 5, 6 um die Achse D2, ist es zur Ausbildung eines zweiten Zustands des Deckelsystems 1 ausreichend, wenn die zweite Kante 11 des zweiten Deckelteils 6 (unter Zugrundelegung der Zeichnung in Fig. 1) in Richtung unterhalb der Zeichenebene bewegt wird. Aufgrund der Verbindung der beiden Deckelteile 5 und 6 erfolgt dabei zwangsweise auch eine Bewegung der ersten Kante 7 des ersten Deckelteils 5 um die Achse D1 um einen ersten vorgebbaren Winkel in die vorgegebene Richtung R, wird die erste Kante 8 des zweiten Deckelteils 6 um die Achse D2 um einen zweiten vorgebbaren Winkel in die vorgebbare Richtung R bewegt, und wird die erste Kante 8 des zweiten Deckelteils 6 in die vorgebbare Richtung R' um eine vorgebbare Strecke relativ zu der Fläche bewegt, die durch die vier Eckbereiche E1, E2, E3, E4 der geschlossenen Fläche definiert ist.

Hierbei aber auch generell ist es erforderlich, dass die Position der ersten Kante 6 des ersten Deckelteils 5 festgelegt ist. Eine solche Festlegung (Fixierung) kann bspw. an einer Umrandung 10 oder an einem oberen Ende einer Wandung des Gehäuses 2 vorgesehen sein.

Eine Ausgestaltung des Deckelsystems 1 gemäß dem letzten obigen Spiegelstrich ist jedoch lediglich eine optionale Ausgestaltung und es können selbstverständlich der erste Deckelteil 5 und der zweite Deckelteil 6 unabhängig voneinander sein und somit auch vollständig unabhängig voneinander bewegbar sein.

Wie Figur 5 entnommen werden kann, kann durch das Deckelsystem 1 gemäß der vorliegenden Erfindung auf technisch einfache Weise ein sehr kompaktes Gehäuse 2 für eine bildgebende Einrichtung 3 und eine Optikeinheit 4 für ein Head-Up-Display realisiert werden, bei der ein "gefalteter" Strahlengang 14 für das von der bildgebenden Einrichtung 3 abgestrahlten Lichts Verwendung findet.

Hierzu kann eine Optikeinheit 4 verwendet werden, die in ihrer einfachsten Ausführungsform (bspw. für ein Combiner-Head-Up-Display) lediglich einen (planaren oder asphärischen) Spiegel (Faltspiegel) zum Umlenken und Projizieren des von der bildgebenden Einrichtung 3 abgestrahlten Lichts zu einer Reflektionsfläche 13 aufweist.

Da trotz der überaus vorteilhaften Ausgestaltung des Deckelsystems 1 sowie des Gehäuses 2 gemäß der vorliegenden Erfindung nicht ausgeschlossen werden kann, dass sich bspw. staubförmige Verunreinigungen auf eine in dem Gehäuse 2 angeordnete bildgebende Einrichtung 3 und/oder Optikeinheit 4 absetzten, die während dem zweiten, geöffneten Zustand des Deckelsystems 1 in das Gehäuse 2 eindringen, kann in vorteilhafter Weise vorgesehen sein, dass bei dem Deckelsystem 1 an der ersten Kante 8 und/oder an der zweiten Kante 11 des zweiten Deckelteils 6 ein Abstreifmittel angeordnet ist. Ein solches Abstreifmittel kann etwa eine Bürstenform mit geeigneten Natur- und/oder Kunststofffasern umfassen oder eine lappenartige Form, etwa aus einem elektrostatisch aufladbaren Material, aufweisen.

Wenn ein solches Abstreifmittel in geeigneter Weise an der ersten Kante 8 und/oder an der zweiten Kante 11 des zweiten Deckelteils 6 angeordnet ist, und der zweite Deckelteil 6, die bildgebende Einrichtung 3 und/oder die Optikeinheit 4 in geeigneter Weise zueinander angeordnet sind, kann sowohl bei einem Bewegen des zweiten Deckelteils 6 von einem ersten, geschlossenen Zustand zu einem zweiten, geöffneten Zustand als auch bei einem Bewegen des zweiten Deckelteils 6 von einem zweiten, geöffneten Zustand zu einem ersten, geschlossenen Zustand das Abstreifmittel über die Oberfläche der bildgebenden Einrichtung 3 und/oder der Optikeinheit 4 streifen und so Verunreinigungen von dieser Einrichtung 3 und/oder Einheit 4 entfernen.

Bei der in den Fig. 2 bis 5 dargestellten Reflektionsfläche handelt es sich um eine sog. Combinerscheibe 13, mit der im Vergleich zu Head-Up-Displays, bei denen das von der bildgebenden Einrichtung 3 abgestrahlte Licht auf eine Freiformfläche, wie etwa eine Frontscheibe eines Kraftfahrzeugs projiziert wird, vergleichsweise preiswerte Combiner-Head-Up-Displays (cHUDs) realisiert werden können.

Bei einem Frontscheiben-Head-Up-Display ist nämlich die Frontscheibe in den optischen Pfad integriert, was aufgrund der Freiformflächengestalt der Frontscheibe nur geringe Toleranzen für die bzw. ein hohe Präzision bei der Optikeinheit 4 und insbesondere dem darin verwendeten Spiegel erfordert. Bei einem Combiner-Head-Up-Display wird dagegen eine in ihren optischen Eigenschaften optimierte Combinerscheibe 13 in den optischen Pfad eingebracht, die im Gegensatz zu einer Freiformfläche eine vergleichsweise einfache Krümmung aufweist, wodurch sich geringere Anforderungen an die Präzision der Optikeinheit 4 ergeben.

Und für eine Einstellung der "eye box" eines Combiner-Head-Up-Display ist die Combinerscheibe 13 in aller Regel schwenkbar ausgestaltet. Eine Einstellung der "eye box" ist erforderlich, wenn ein Nutzer die von dem Head-Up-Display angezeigte Information 15 nicht oder nicht vollständig sehen kann.

Das Deckelsystem 1 sowie das Gehäuse 2 mit dem Deckelsystem 1 ist nicht auf eine Verwendung bei Combiner-Head-Up-Displays beschränkt, sondern kann selbstverständlich auch für solche Head-Up-Displays verwendet werden, bei denen das von der bildgebenden Einrichtung 3 abgestrahlte Licht auf eine Freiformfläche abgestrahlt wird, wie etwa bei einem Frontscheiben-Head-Up-Display. In einem solchen Fall ist es erforderlich, dass die Optikeinheit 4 dazu eingerichtet ist, das von der bildgebenden Einrichtung 3 abgestrahlte Licht so abzustrahlen, dass die von dem Head-Up-Display angezeigten Information für einen Nutzer sichtbar sind, d.h. innerhalb der "eye box" erscheinen. Hierzu kann es ausreichend sein, einen bewegbaren (planaren oder asphärischen) Spiegel in dem Gehäuse 2 vorzusehen. Die Head-Up-Displays können auch als sog. "Augmented reality"-Head-Up-Displays ausgebildet sein.

Selbstverständlich kann die Optikeinheit 4 weitere Elemente aufweisen, wie etwa eine oder mehrere Linsen, mit denen etwa die Funktion eines Kollimators realisiert wird.

Wie aus Fig. 5 weiter entnehmbar ist, kann eine Optikeinheit 4 in Form eines Spiegels (Faltspiegel) an einer Wandung des Gehäuses 2 vorgesehen sein, die sich parallel zu den Enden der ersten Kante 8 des zweiten Gehäuseteils 6 erstreckt und der, sofern erforderlich oder wünschenswert, um wenigstens eine seiner Achsen (bspw. elektromotorisch) beweglich an der Wandung angebracht ist. Und eine bildgebende Einrichtung 3 kann bspw. im Bereich "unterhalb" (gemäß der in den Figuren gezeigten Ausrichtung) des ersten Deckelteils 5 angeordnet sein.

Eine fester erster vorgebbarer Winkel, um den die erste Kante 7 des ersten Deckelteils 5 um die Achse D1 bewegt werden kann, kann auf einfache Weise dadurch realisiert werden, dass eine oder beide zu seiner ersten Kante 7 unmittelbar benachbarte(n) Kante(n).des ersten Deckelteils 5 mittels eines entsprechend ausgestalteten, flexiblen Elements mit einer Umrandung 10 für das Deckelsystem 1 verbunden ist/sind. Bei einem solchen "flexiblen Element" kann es sich bspw. um ein Material handeln, dass selbst flexible Eigenschaften aufweist, wie etwa ein dünnes Kunststoffmaterial, oder bei dem die Flexibilität bspw. durch ein Gelenk erreicht wird. Das "flexible Element" kann sich etwa vollständig entlang des/der Kante(n) (und entsprechend dazu entlang der Umrandung 10) erstrecken oder nur an einem Abschnitt davon befestigt sein.

Wird der erste Deckelteil 5 zur Ausbildung des zweiten Zustands des Deckelsystems 1 so weit in Richtung R bewegt, dass sich das flexible Element in einem "gestreckten" Zustand befindet, kann der erste Deckelteil 5 nicht mehr weiterbewegt werden und nimmt so die für den zweiten Zustand vorgesehene Position mit dem vorgegebenen Winkel ein.

In ähnlicher Weise kann auch vorgesehen sein, dass eine oder beide zu seiner ersten Kante 8 unmittelbar benachbarte(n) Kante(n) des zweiten Deckelteils 6 mittels eines flexiblen Elements mit dem ersten Deckelteil 5 verbunden ist/sind. Bezüglich des "flexiblen Elements" gelten die obigen Ausführungen entsprechend.

Ist das erste Deckelteil 5 mittels wenigstens einem flexiblen Element mit einer Umrandung 10 verbunden und ist das zweite Deckelteil 6 mittels wenigstens einem flexiblen Element mit dem ersten Deckelteil 5 verbunden, so ergeben sich der erste vorgebbare Winkel für den ersten Deckelteil 5, der zweite vorgebbare Winkel für den zweiten Deckelteil 6 sowie die vorgebbare Strecke, um die erste Kante 8 des zweiten Deckelteils 6 bewegt werden kann, auf einfache Weise aus der Ausgestaltung des ersten 5 und zweiten 6 Deckelteils sowie aus der Ausgestaltung der jeweiligen flexiblen Elemente.

Sofern vorstehend von "unmittelbar benachbarten" Kanten gesprochen wird, so sind darunter Kanten zu verstehen, die maximal durch einen Eckbereich des jeweiligen Deckelteils 5, 6 voneinander beabstandet sind.

Ein vorgebbarer erster vorgebbarer Winkel für den ersten Deckelteil 5, ein zweiter vorgebbarer Winkel für den zweiten Deckelteil 6 und/oder eine vorgebbare Strecke für die erste Kante 8 des zweiten Deckelteils 6 kann jedoch alternativ oder ergänzend auch auf einfache Weise mittels jeweils wenigstens eines Endanschlagelements 12 erreicht werden, von denen lediglich einer für den ersten Deckelteil 5 in den Fig. 3 und 4 beispielhaft dargestellt ist.

Das/Die flexiblen Element(e) oder das/die Endanschlagelement(e) 12 ist/sind selbstverständlich außerhalb des Strahlengangs 14 anzuordnen.

Zum Bewegen des ersten Deckelteils 5 und/oder des zweiten Deckelteils 6 von dem ersten Zustand zu dem zweiten Zustand und/oder von dem zweiten Zustand zu dem ersten Zustand, sowie wahlweise zum Halten des ersten Deckelteils 5 und/oder des zweiten Deckelteils 6 im ersten Zustand und/oder im zweiten Zustand, kann das Gehäuse 2 gemäß der vorliegenden Erfindung wenigstens ein (in den Figuren nicht dargestelltes) elektromotorisches, elektropneumatisches, elektrohydraulisches und/oder Feder-Mittel aufweisen. Ein elektromotorisches Mittel kann bspw. eine Zahnstange oder eine Gewindestange umfassen, ein elektropneumatisches oder elektrohydraulisches Mittel kann bspw. einen mittels eines Gases oder einer Flüssigkeit beweglichen Kolben umfassen und ein Feder-Mittel kann bspw. eine Blatt- oder eine Schraubenfeder umfassen.

Für ein lösbares Halten des ersten 5 und/oder zweiten 6 Deckelteils in dem ersten und/oder zweiten Zustand kann auch wenigstens ein Haltemittel bei dem Gehäuse 2 vorgesehen sein, etwa in Form einer lösbaren Schnapp-oder Rastverbindung.

In einer einfachsten Ausführungsform können somit der erste Deckelteil 5 und der zweite Deckelteil 6 des Deckelsystems 1 etwa mittels eines FederMittels in einem ersten, geschlossenen Zustand gehalten werden. Durch einen Druck auf den ersten 5 und/oder zweiten 6 Deckelteil, etwa durch einen Finger oder eine Hand eines Menschen, kann der erste Deckelteil 5 und der zweite Deckelteil 6 von dem ersten, geschlossenen Zustand zu dem zweiten, geöffneten Zustand bewegt werden. In diesem Zustand können der erste Deckelteil 5 und der zweite Deckelteil 6 mittels eines Haltemittels, etwa in Form einer lösbaren Schnapp- oder Rastverbindung so lange gehalten werden, bis die Schnapp- oder Rastverbindung, etwa durch einen erneuten Druck auf den oder einen Zug an dem ersten 5 und/oder zweiten 6 Deckelteil wieder gelöst wird und die beiden Deckelteile 5, 6 durch das Feder-Mittel wieder in den ersten, geschlossenen Zustand zurückbewegt werden.

In einer fortgeschritteneren Ausführungsform kann vorgesehen sein, dass bei einem Einschalten eines Head-Up-Display, das ein Gehäuse 2 gemäß der vorliegenden Erfindung aufweist, der erste 5 und der zweite 6 Deckelteil etwa mittels eines elektromotorischen, elektropneumatischen oder elektrohydraulischen Mittels von einem ersten, geschlossenen Zustand zu einem zweiten, geöffneten Zustand bewegt und dort so lange in diesem Zustand gehalten werden, solange das Head-Up-Display aktiviert ist. Bei einem Ausschalten des Head-Up-Display können dann der erste 5 und der zweite 6 Deckelteil mittels des elektromotorischen, elektropneumatischen oder elektrohydraulischen Mittels wieder von dem zweiten, geöffneten Zustand zu dem ersten, geschlossenen Zustand zurückbewegt werden.

Bezüglich des Materials des Deckelsystems 1 bzw. des dabei verwendeten ersten 5 und zweiten 6 Deckelteils (sowie weiterer möglicher Deckelteile) bestehen keine besonderen Einschränkungen. Für ein Head-Up-Display in einem Kraftfahrzeug ist es jedoch von Vorteil, wenn das Material ein hohes Absorptionsvermögen für Licht aufweist, bspw. eine matte, strukturierte und/oder eine mit einer Anti-Reflex-Beschichtung versehene Oberfläche aufweist, damit das Deckelsystem 1 nicht oder so wenig wie möglich in der Reflektionsfläche 13 sichtbar ist. Entsprechende Überlegungen gelten für das Material für das/die oben beschriebene(n) flexible(n) Element(e), für das/die Endanschlagelemente 12 sowie das Material der Innenseite des Gehäuses 2.

Das Material des Deckelsystems 1 kann identisch oder verschieden von dem Material einer Umrandung 10 für das Deckelsystem 1 sein. Bei der Umrandung 10 für das Deckelsystem 1 kann es sich bspw. um einen Teil der Schalttafel oder des Armaturenbretts eines Kraftfahrzeugs, um einen Bestandteil des Gehäuses 2, etc. handeln.

Soweit in der vorliegenden Anmeldung der Begriff "Combiner-Einrichtung" verwendet wird, so ist darunter eine Einrichtung zu verstehen, die zumindest dazu eingerichtet ist, eine Combinerscheibe 13 für eine Einstellung der "eye box" eines Combiner-Head-Up-Display schwenkbar zu halten. Die Combiner-Einrichtung kann ein entsprechend eingerichtetes Gehäuse umfassen.

Zusammenfassend kann man festhalten, dass immer mehr Kraftfahrzeuge mit Head-Up-Display-Systemen ausgerüstet werden. Ein kostengünstige Variante derartiger Head-Up-Display-Systeme stellt ein sog. Combiner-Head-Up-Display (cHUD) mit einer Combinerscheibe dar. Eine besondere Herausforderung stellt die Integration in eine Schalttafel oder in ein Armaturenbrett im Bereich der Hutze dar. Im Betriebszustand "AUS" soll das cHUD und dessen optische Elemente (bilderzeugende Einrichtung und Optikeinheit) weitestgehend von einem Deckel verschlossen eine sein, um Verunreinigungen dieser Elemente möglichst gering zu halten.

Bekannte Deckellösungen sind im allg. sehr aufwendig seitens der Kinematik und benötigen viel zusätzlichen Bauraum.

Erfindungsgemäß wird daher ein Deckelsystem 1 vorgeschlagen, das im geschlossenen Zustand das optische System oberflächenbündig (bspw. zur Hutze Strak-bündig) abdeckt. Im geöffneten Zustand wird aus den einzelnen Elementen des Deckels der optische Pfad gebildet und gibt den Lichtkanal des Head-Up-Display-Systems frei. Das vorgeschlagene Deckelsystem 1 und das vorgeschlagene Gehäuse 2 eignen sich insbesondere für cHUDs, jedoch ist das vorgeschlagene Deckelsystem 1 und das vorgeschlagene Gehäuse 2 nicht hierauf beschränkt. So kann das vorgeschlagene Deckelsystem 1 und das vorgeschlagene Gehäuse 2 etwa auch bei allen anderen Arten von Head-Up-Displays Verwendung finden.

Das vorgeschlagene Deckelsystem 1 ermöglicht eine kostengünstige Doppelnutzung des Deckelsystems 1 zur Abdeckung und Lichtkanalgestaltung, erfordert lediglich eine einfache Kinematik, ermöglicht die Verwendung eines bauraumoptimierten gefalteten Strahlengangs 14, ermöglicht ein Gehäuse 2 mit nur einem kleinen geöffneten Volumen, wodurch ein Eintrag von Verunreinigungen in das Gehäuse 2 bei einem geöffneten Zustand des Deckelsystems 1 gering gehalten werden kann, erfordert keinen Eingriff in und keine Bewegung des optischen Systems 3, 4 eines Head-Up-Display und reduziert Lichtreflexe durch das Deckelsystem 1 auf ein Minimum, da die durch das Deckelsystem 1 freigebbare Öffnung auf den Bereich des Strahlengangs 14 beschränkbar ist.

Auch wenn das Deckelsystem 1 und das Gehäuse 2 in der vorliegenden Anmeldung überwiegend im Zusammenhang mit Kraftfahrzeugen beschrieben ist, ist der Schutzbereich der nachfolgenden Patentansprüche selbstverständlich nicht auf die Verwendung oder Integration des Deckelsystems 1 und des Gehäuses 2 in Kraftahrzeugen beschränkt.

## Patentansprüche

1. Deckelsystem (1) zum Öffnen und Schließen einer Seite eines Gehäuses (2), das zur Aufnahme einer bildgebenden Einrichtung (3) und einer Optikeinheit (4) für ein Head-Up-Display vorgesehen ist,
wobei
- das Deckelsystem (1) wenigstens einen ersten Deckelteil (5) und einen zweiten Deckelteil (6) aufweist,
- der erste Deckelteil (5) und der zweite Deckelteil (6) in einem ersten Zustand aneinandergrenzen und zusammen eine geschlossene Fläche mit vier Eckbereichen (E1, E2, E3, E4) ausbilden,
- eine erste Kante (7) des ersten Deckelteils (5) eine äußere Kante der geschlossenen Fläche ausbildet, wobei die Enden der ersten Kante (7) des ersten Deckelteils (5) unmittelbar an zwei erste benachbarte Eckbereiche (E1, E2) der geschlossenen Fläche angrenzen,
- eine erste Kante (8) des zweiten Deckelteils (6) zumindest einen Teil einer weiteren äußeren Kante der geschlossenen Fläche ausbildet, wobei die Enden der ersten Kante (8) des zweiten Deckelteils (6) entweder unmittelbar an zwei zweite benachbarte, von den zwei ersten benachbarten Eckbereichen (E1, E2) verschiedene Eckbereiche (E3, E4) der geschlossenen Fläche angrenzen oder in der Kante der geschlossenen Fläche angeordnet sind, die sich zwischen den zwei zweiten benachbarten Eckbereichen (E3, E4) der geschlossenen Fläche erstreckt,
und zur Ausbildung eines zweiten Zustands
- die erste Kante (7) des ersten Deckelteils (5) um eine Achse D1, die parallel zu einer durch die Enden der ersten Kante (7) des ersten Deckelteils (5) gedachten Geraden verläuft, um einen ersten vorgebbaren Winkel in eine vorgebbare Richtung (R) beweglich ist,
- die erste Kante (8) des zweiten Deckelteils (6) um eine Achse D2, die parallel zu einer durch die Enden der ersten Kante (8) des zweiten Deckelteils (6) gedachten Geraden verläuft, um einen zweiten vorgebbaren Winkel in die vorgebbare Richtung (R) beweglich ist, und
- die erste Kante (8) des zweiten Deckelteils (6) in eine vorgebbare Richtung (R') um eine vorgebbare Strecke relativ zu der Fläche beweglich ist, die durch eine gedachte geradlinige Verbindung der vier Eckbereiche (E1, E2, E3, E4) der geschlossenen Fläche definiert ist,
**dadurch gekennzeichnet, dass**
- der erste Deckelteil (5) wenigstens eine zweite Kante (9) aufweist, die mit der Kante der geschlossenen Fläche fluchtet, die sich zwischen den zweiten zwei benachbarten Eckbereichen (E3, E4) der geschlossenen Fläche erstreckt und
- der erste Deckelteil (5) im Bereich seiner wenigstens einen zweiten Kante (9) und der zweite Deckelteil (6) im Bereich seiner ersten Kante (8) um die Achse D2 gegeneinander verdrehbar miteinander verbunden sind.

2. Deckelsystem (1) gemäß Anspruch 1,
**dadurch gekennzeichnet, dass**
bei der durch den ersten (5) und den zweiten (6) Deckelteil im ersten Zustand ausgebildeten geschlossenen Fläche die Länge der Kante zwischen den zwei ersten Eckbereichen (E1, E2) der geschlossenen Fläche größer ist als die Länge der Kante zwischen den zwei zweiten Eckbereichen (E3, E4) der geschlossenen Fläche.

3. Deckelsystem (1) gemäß Anspruch 2,
**dadurch gekennzeichnet, dass**
der zweite Deckelteil (6) eine Fläche mit vier Eckbereichen aufweist, wobei die Enden der ersten Kante (8) des zweiten Deckelteils (6) zwei ersten benachbarten Eckbereichen des zweiten Deckelteils (6) entsprechen, und die Enden einer zweiten Kante (11) des zweiten Deckelteils (6) zwei zweiten benachbarten, von den zwei ersten benachbarten Eckbereichen des zweiten Deckelteils (6) verschiedenen Eckbereichen des zweiten Deckelteils (6) entsprechen, und wobei die erste Kante (8) eine größere Länge aufweist als die zweite Kante (11).

4. Deckelsystem (1) gemäß einem der vorhergehenden Ansprüche,
**dadurch gekennzeichnet, dass**
- eine oder beide zu seiner ersten Kante (7) unmittelbar benachbarte(n) Kante(n) des ersten Deckelteils (5) mittels eines flexiblen Elements mit einer Umrandung (10) für das Deckelsystem (1) verbunden ist/sind, und/oder
- eine oder beide zu seiner ersten Kante (8) unmittelbar benachbarte(n) Kante(n) des zweiten Deckelteils (6) mittels eines flexiblen Elements mit dem ersten Deckelteil (5) verbunden ist/sind.

5. Deckelsystem (1) gemäß einem der vorhergehenden Ansprüche,
**dadurch gekennzeichnet, dass**
an der ersten Kante (8) und/oder an der zweiten Kante (11) des zweiten Deckelteils (6) ein Abstreifmittel angeordnet ist.

6. Gehäuse (2), das zur Aufnahme einer bildgebenden Einrichtung (3) und einer Optikeinheit (4) für ein Head-Up-Display vorgesehen ist,
**dadurch gekennzeichnet, dass**
das Gehäuse (2) ein Deckelsystem (1) gemäß einem der Ansprüche 1 bis 5 aufweist.

7. Gehäuse (2) gemäß Anspruch 6,
**dadurch gekennzeichnet, dass**
es ein elektromotorisches, elektropneumatisches, elektrohydraulisches und/oder Feder-Mittel zum Bewegen des ersten Deckelteils (5) und/oder des zweiten Deckelteils (6) von dem ersten Zustand zu dem zweiten Zustand und/oder von dem zweiten Zustand zu dem ersten Zustand aufweist.

8. Gehäuse (2) gemäß einem der Ansprüche 6 oder 7,
**dadurch gekennzeichnet, dass** es
- ein Haltemittel zum lösbaren Halten des ersten (5) und/oder zweiten (6) Deckelteils in dem ersten und/oder zweiten Zustand, und/oder
- wenigstens ein Endanschlagelement (12) für den ersten (5) und/oder zweiten (6) Deckelteil
aufweist.

9. Gehäuse (2) gemäß einem der Ansprüche 6 bis 8
**dadurch gekennzeichnet, dass**
- es mit einer Combiner-Einrichtung mit einer Combinerscheibe (13) verbunden ist oder eine Combinerscheibe (13) aufweist;
- eine bildgebende Einrichtung (3) aufweist, die Flüssigkristalle, Licht emittierende Dioden, organische Licht emittierende Dioden, eine Elektrolumineszenzeinrichtung, eine Feldemissionseinrichtung, ein Mikrospiegelarray und/oder eine Elektronenstrahlröhre aufweist; und/oder
- eine Optikeinheit (4) aufweist, die einen Spiegel zum Projizieren des von der bildgebenden Einrichtung (3) abgestrahlten Lichts zu einer Reflektionsfläche (13) aufweist.

## Claims

1. A cover system (1) for opening and closing a side of a housing (2) which is provided for the reception of an imaging device (3) and an optical unit (4) for a head-up display,
wherein
- the cover system (1) has at least one first cover part (5) and one second cover part (6),
- the first cover part (5) and the second cover part (6) adjoin one another in a first state and together form a closed surface having four corner sections (E1, E2, E3, E4)
- a first edge (7) of the first cover part (5) forms an outer edge of the closed surface, wherein the ends of the first edge (7) of the first cover part (5) immediately adjoin first two adjacent corner sections (E1, E2) of the closed surface,
- a first edge (8) of the second cover part (6) forms at least a part of a further outer edge of the closed surface, wherein the ends of the first edge (8) of the second cover part (6) either immediately adjoin second two adjacent corner sections (E3, E4), different from the first two adjacent corner sections (E1, E2) of the closed surface, or are located in the edge of the closed surface, which extends between the second two adjacent corner sections (E3, E4) of the closed surface and for the formation of a second state
- the first edge (7) of the first cover part (5) is movable in a definable direction (R) about a first definable angle about an axis D1 which extends parallel to an imaginary straight line through the ends of the first edge (7) of the first cover part (5),
- the first edge (8) of the second cover part (6) is movable in the definable direction (R) about a second definable angle about an axis D2 which extends parallel to an imaginary straight line through the ends of the first edge (8) of the second cover part (6), and
- the first edge (8) of the second cover part (6) is movable in a definable direction (R') by a definable distance relative to the surface which is defined by an imaginary rectilinear connection of the four corner sections (E1, E2, E3, E4) of the closed surface,
**characterised in that**
- the first cover part (5) has at least one second edge (9), which is aligned with the edge of the closed surface, which extends between the second two adjacent corner sections (E3, E4) of the closed surface and
- the first cover part (5) in the region of its at least one second edge (9) and the second cover part (6) are attached together in the region of its first edge (8) such as to be rotatable relative to one another about the axis D2.

2. Cover system (1) according to claim 1,
**characterised in that**
in the case of the closed surface formed by the first (5) and second (6) cover parts in the first state, the length of the edge between the first two corner sections (E1, E2) of the closed surface is greater than the length of the edge between the second two corner sections (E3, E4) of the closed surface.

3. Cover system (1) according to claim 2,
**characterised in that**
the second cover part (6) has a surface with four corner sections, wherein the ends of the first edge (8) of the second cover part (6) correspond with first two adjacent corner sections of the second cover part (6), and the ends of a second edge (11) of the second cover part (6) correspond with second two adjacent corner sections, different from the first two adjacent corner sections of the second cover part (6), of the second cover part (6), and wherein the first edge (8) has a greater length than the second edge (11).

4. Cover system (1) according to any of the preceding claims,
**characterised in that**
- one or both edges, immediately adjacent to its first edge (7), of the first cover part (5) is/are connected with a border (10) for the cover system (1) by means of a flexible element, and/or
- one or both edges, immediately adjacent to its first edge (8), of the second cover part (6) are connected with the first cover part (5) by means of a flexible element.

5. Cover system (1) according to any of the preceding claims,
**characterised in that**
a wiping means is disposed on the first edge (8) and/or the second edge (11) of the second cover part (6).

6. Housing (2) which is provided for the reception of an imaging device (3) and an optical unit (4) for a head-up display,
**characterised in that**
the housing (2) has a cover system (1) according to any of claims 1 to 5.

7. Housing (2) according to claim 6
**characterised in that**
it has an electromotive, Electropneumatic, Electrohydraulic and/or spring means for moving the first cover part (5) and/or the second cover part (6) from the first state to the second state and/or from the second state to the first state.

8. Housing (2) according to any of claims 6 or 7,
**characterised in that** it has
- a retaining means for releasably retaining the first (5) and/or the second (6) cover part in the first and/or second state, and/or
- at least one end-stop element (12) for the first (5) and/or second (6) cover part.

9. Housing (2) according to any of claims 6 to 8,
**characterised in that**
- it is connected with a combiner system with a combiner disk (13) or has a combiner disk (13);
- has an imaging device (3) which has liquid crystals, light emitting diodes, organic light emitting diodes, an electroluminescent device, a field emission device, a micromirror array, and/or a cathode ray tube; and/or
- has an optical unit (4) which has a mirror for projecting the light emitted by the imaging device (3) to a reflective surface (13).

## Revendications

1. Système de recouvrement (1) pour ouvrir et fermer un côté d'un boîtier (2), qui est prévu pour la réception d'un dispositif d'imagerie (3) et d'une unité optique (4) pour un affichage tête haute,
dans lequel
- le système de recouvrement (1) présente au moins une première partie de recouvrement (5) et une deuxième partie de recouvrement (6),
- la première partie de recouvrement (5) et la deuxième partie de recouvrement (6) sont contigües l'une à l'autre dans un premier état et forment ensemble une surface fermée avec quatre zones d'angle (E1, E2, E3, E4),
- une première arête (7) de la première partie de recouvrement (5) forme une arête extérieure de la surface fermée, dans lequel les extrémités de la première arête (7) de la première partie de recouvrement (5) sont contigües directement à deux premières zones d'angle (E1, E2) adjacentes de la surface fermée,
- une première arête (8) de la deuxième partie de recouvrement (6) forme au moins une partie d'une autre arête extérieure de la surface fermée, dans lequel les extrémités de la première arête (8) de la deuxième partie de recouvrement (6) sont soit contigües directement à deux deuxièmes zones d'angle (E3, E4) adjacentes, différentes des deux premières zones d'angle (E1, E2) adjacentes de la surface fermée soit sont agencées dans l'arête de la surface fermée, qui s'étend entre les deuxièmes zones d'angle (E3, E4) adjacentes de la surface fermée,
et pour la formation d'un deuxième état
- la première arête (7) de la première partie de recouvrement (5) est mobile autour d'un axe D1, qui s'étend parallèlement à une droite imaginaire par les extrémités de la première arête (7) de la première partie de recouvrement (5), d'un premier angle pouvant être prédéfini dans une direction pouvant être prédéfinie (R),
- la première arête (8) de la deuxième partie de recouvrement (6) est mobile autour d'un axe D2, qui s'étend parallèlement à une droite imaginaire par les extrémités de la première arête (8) de la deuxième partie de recouvrement (6), d'un deuxième angle pouvant être prédéfini dans la direction pouvant être prédéfinie (R), et
- la première arête (8) de la deuxième partie de recouvrement (6) est mobile dans une direction pouvant être prédéfinie (R') d'une distance pouvant être prédéfinie par rapport à la surface, qui est définie par une liaison rectiligne imaginaire des quatre zones d'angle (E1, E2, E3, E4) de la surface fermée,
**caractérisé en ce que**
- la première partie de recouvrement (5) présente au moins une deuxième arête (9), qui est alignée avec l'arête de la surface fermée, qui s'étend entre les deuxièmes deux zones d'angle (E3, E4) adjacentes de la surface fermée et
- la première partie de recouvrement (5) dans la zone de sa au moins une deuxième arête (9) et la deuxième partie de recouvrement (6) dans la zone de sa première arête (8) sont reliées l'une à l'autre de manière rotative l'une par rapport à l'autre autour de l'axe D2.

2. Système de recouvrement (1) selon la revendication 1,
**caractérisé en ce que**
pour la surface fermée formée par la première (5) et la deuxième (6) partie de recouvrement dans le premier état, la longueur de l'arête entre les deux premières zones d'angle (E1, E2) de la surface fermée est supérieure à la longueur de l'arête entre les deux deuxièmes zones d'angle (E3, E4) de la surface fermée.

3. Système de recouvrement (1) selon la revendication 2,
**caractérisé en ce que**
la deuxième partie de recouvrement (6) présente une surface avec quatre zones d'angle, dans lequel les extrémités de la première arête (8) de la deuxième partie de recouvrement (6) correspondent à deux premières zones d'angle adjacentes de la deuxième partie de recouvrement (6), et les extrémités d'une deuxième arête (11) de la deuxième partie de recouvrement (6) correspondent à deux deuxièmes zones d'angle adjacentes de la deuxième partie de recouvrement (6), différentes des deux premières zones d'angle adjacentes de la deuxième partie de recouvrement (6), et dans lequel la première arête (8) présente une plus grande longueur que la deuxième arête (11).

4. Système de recouvrement (1) selon l'une quelconque des revendications précédentes,
**caractérisé en ce que**
- une ou les deux arête(s) directement adjacente(s) à sa première arête (7) de la première partie de recouvrement (5) est/sont reliées à une bordure (10) pour le système de recouvrement (1) au moyen d'un élément souple, et/ou
- une ou les deux arête(s) directement adjacente(s) à sa première arête (8) de la deuxième partie de recouvrement (6) est/sont reliées à la première partie de recouvrement (5) au moyen d'un élément souple.

5. Système de recouvrement (1) selon l'une quelconque des revendications précédentes,
**caractérisé en ce que**
un moyen de raclage est agencé au niveau de la première arête (8) et/ou au niveau de la deuxième arête (11) de la deuxième partie de recouvrement (6).

6. Boîtier (2), qui est prévu pour la réception d'un dispositif d'imagerie (3) et d'une unité optique (4) pour un affichage tête haute,
**caractérisé en ce que**
le boîtier (2) présente un système de recouvrement (1) selon l'une quelconque des revendications 1 à 5

7. Boîtier (2) selon la revendication 6,
**caractérisé en ce que**
il présente un moyen électromoteur, électropneumatique, électrohydraulique et/ou à ressort pour le déplacement de la première partie de recouvrement (5) et/ou de la deuxième partie de recouvrement (6) du premier état au deuxième état et/ou du deuxième état au premier état.

8. Boîtier (2) selon l'une quelconque des revendications 6 ou 7,
**caractérisé en ce qu'**il présente
- un moyen de retenue pour la retenue amovible de la première (5) et/ou deuxième (6) partie de recouvrement dans le premier et/ou deuxième état, et/ou
- au moins un élément de butée de fin de course (12) pour la première (5) et/ou deuxième (6) partie de recouvrement.

9. Boîtier (2) selon l'une quelconque des revendications 6 à 8,
**caractérisé en ce que**
- il est relié à un dispositif de combinaison avec une vitre de combinaison (13) ou présente une vitre de combinaison (13) ;
- présente un dispositif d'imagerie (3), qui présente des cristaux liquides, des diodes électroluminescentes, des diodes électroluminescentes organiques, un dispositif électroluminescent, un dispositif d'émission de champ, un réseau de micro-miroirs et/ou un tube cathodique ; et/ou
- présente une unité optique (4), qui présente un miroir pour la projection de la lumière émise par le dispositif d'imagerie (3) vers une surface de réflexion (13).
